# EUROPÄISCHE PATENTSCHRIFT

(11) **EP 2 331 726 B1**
(45) Veröffentlichungstag und Bekanntmachung des Hinweises auf die Patenterteilung: **01.11.2017**
(21) Anmeldenummer: 09777750.2
(22) Anmeldetag: 07.08.2009
(51) Int. Cl.: H01L 21/285, C23C 16/04, C23C 16/48, C23C 16/16, H01L 21/768

(54) **VERFAHREN ZUM ELEKTRONENSTRAHLINDUZIERTEN ABSCHEIDEN VON LEITFÄHIGEM MATERIAL**
METHOD FOR ELECTRON BEAM INDUCED DEPOSITION OF CONDUCTIVE MATERIAL
PROCÉDÉ POUR LE DÉPÔT, SOUS L'EFFET D'UN FAISCEAU D'ÉLECTRONS, D'UN MATÉRIAU CONDUCTEUR

(30) Priorität: 14.08.2008 DE 102008037944
(43) Veröffentlichungstag der Anmeldung: 15.06.2011
(73) Patentinhaber: Carl Zeiss SMT GmbH, 73447 Oberkochen (DE)
(72) Erfinder: AUTH, Nicole, 65462 Gustavsburg (DE); SPIES, Petra, 55130 Mainz (DE); BECKER, Rainer, 64319 Pfungstadt (DE); HOFMANN, Thorsten, 63110 Rodgau (DE); EDINGER, Klaus, 64653 Lorsch (DE)
(74) Vertreter: Wegner, Hans
(86) Internationale Anmeldenummer: PCT/EP2009/005758
(87) Internationale Veröffentlichungsnummer: WO 2010/017920

(56) Entgegenhaltungen:
- EP-A2- 0 130 398
- UTKE I ET AL: "Cross section investigations of compositions and sub-structures of tips obtained by focused electron beam induced deposition" ADVANCED ENGINEERING MATERIALS WILEY-VCH VERLAG GMBH GERMANY, Bd. 7, Nr. 5, Mai 2005 (2005-05), Seiten 323-331, XP002551163 ISSN: 1438-1656
- LAU Y M ET AL: "Properties and applications of cobalt-based material produced by electron-beam-induced deposition" JOURNAL OF VACUUM SCIENCE AND TECHNOLOGY: PART A, AVS /AIP, MELVILLE, NY., US, Bd. 20, Nr. 4, 1. Juli 2002 (2002-07-01), Seiten 1295-1302, XP012006123 ISSN: 0734-2101 in der Anmeldung erwähnt

## Beschreibung

### 1. Technisches Gebiet

Die vorliegende Erfindung betrifft ein Verfahren zum elektronenstrahlinduzierten Abscheiden von leitfähigem Material.

### 2. Stand der Technik

In der Halbleitertechnologie sind die Reparatur von Belichtungsmasken und das sogenannte Circuit Editing, d.h. das gezielte Verändern von mikroskopischen Strukturen wichtige Prozesse. Zum Abbilden von Maskendefekten und von mikroelektronischen Schaltungen wird häufig ein Rasterelektronenmikroskop eingesetzt, da Elektronenstrahlen im Gegensatz zu Ionenstrahlen die abgetastete Oberfläche nicht verändern.

Das Abtragen von Material im mikroskopischen Maßstab mit Hilfe eines Elektronenstrahls und eines geeigneten Ätzgases ist bereits etabliert und vielfach beschrieben worden. Die Anmelderin hat in der DE 103 38 019 A1 ein Verfahren zum elektronenstrahlinduzierten Ätzen von Metalloxidschichten offenbart. Ferner hat die Anmelderin in der EP 04 008 972.4 eine Vorrichtung zum Untersuchen und Verändern einer Probe mit Hilfe eines Elektronenstrahls beschrieben.

Zu dem Prozess der Deposition von Material zur Maskenreparatur gibt es ebenfalls bereits ein umfangreiches Schrifttum. Auch die Thematik des Abscheidens von leitfähigem Material beim Circuit Editing zur (Neu-) Verdrahtung von Schaltungsteilen auf mikroskopischer Ebene wurde bisher intensiv untersucht. Der wichtigste Parameter für neu geschaffene elektrisch leitfähige Verbindungen auf mikroskopischer Ebene ist deren spezifischer Widerstand.

In der EP 0130398 wurde erstmals die Verwendung eines Elektronenstrahls zur Deposition von elektrisch leitfähigen Verbindungen aus Nickeltetracarbonyl offenbart. Als Präkursormaterialien mit denen sich leitfähige Materialien mit niedrigem spezifischem Widerstand mit einem Elektronenstrahl deponieren lassen, wurden von der Anmelderin in Übereinstimmung mit der Literatur Metallcarbonyle und Wolframhexafluorid (WF₆) identifiziert. Der letztgenannte Präkursor weist keinen Kohlenstoff auf, der sich in das Deponat einlagern könnte. Die Anmelderin hat jedoch durch umfangreiche Untersuchungen herausgefunden, dass WF₆ Deponate eine grobkörnige Mikrostruktur aufweisen, die einen zuverlässigen und zerstörungsfreien Stromtransport nicht zulassen. Insbesondere beim Füllen von sogenannten Vias mit Hilfe von WF₆ und eines Elektronenstrahls ätzt das bei der Reaktion des Präkursors freiwerdende Fluor die das Via begrenzenden Seitenwände und führt damit zusätzlich zum Einbau von unerwünschten Komponenten in das Deponat.

Beim Verwenden von Metallcarbonylen werden in das entstehende Deponat zwar keine unbekannten Komponenten aus der Probe eingebaut, aber die Zusammensetzung des abgeschiedenen Materials enthält neben dem Metallzentralatom auch Kohlenstoff und Sauerstoff aus den CO-Liganden des Metallcarbonyls. Die Zusammensetzung des Deponats - und damit natürlich auch sein spezifischer elektrischer Widerstand - hängt somit von der Prozessführung bei elektronenstrahlinduziertem Abscheiden ab.

Die Veröffentlichung "Cross section investigations of compositions and sub-structures of tips obtained by focused electron beam induced deposition" von I. Utke et al. in Advanced Engineering Materials 2005, 7, No. 5, S. 323-331, XP002551163 untersucht die räumliche Entwicklung der Zusammensetzung und der Substrukturen innerhalb von Spitzen, die mit Hilfe eines fokussierten Elektronenstrahls aus einem Dikobaltoktocarbonyl-Precursor bei 25 keV und mit einem Strahlstrom in dem Bereich von 20 pA bis 3 µA abgeschieden wurden. Im Temperaturbereich zwischen 20° C und 80° C wandelt sich Dikobaltoktocarbonyl in Tetradodecarbonyl unter Freisetzung von Kohlenstoffmonooxid um. Bei Temperaturen oberhalb von 100° C zerfällt Tetradodecarbonyl in Kobalt und Kohlenstoffmonooxid.

Die Autoren Lau, Chee, Thong und Ng haben leitfähige Nadeln aus Dikobaltoktocarbonyl unter verschiedenen Prozessbedingungen mit Hilfe eines Elektronenstrahls abgeschieden und die Proben analysiert (Y.M. Lau, P.C. Chee, J.T.L. Thong an V. Ng, "Propertiers and applications of cobalt-based material produced by electron-beam induced deposition", J. Vac. Sci. Technol. A 20(4), 1295-1302 (2002)). Dabei zeigte sich, dass geringe Stromstärken des Elektronenstrahls zur Deposition von amorphem Material führen, das elektrisch kaum leitend ist; wohingegen große Stromstärken die Abscheidung von polykristallinem Material mit einem großen Kobaltanteil (bis zu 50 Atom-%) bewirken. Dieser Zusammenhang wurde bei großen Beschleunigungsspannungen der Elektronen und einer gleichfalls großen Verweilzeit (dwell time) des Elektronenstrahls beobachtet.

Beim Füllen von Vias durch Deposition von leitfähigem Material führen große Gasflussmengen des Metallcarbonyls in Kombination mit großen Stromstärken des Elektronenstrahls und hohen Beschleunigungsspannungen jedoch nicht zum Abscheiden von Material mit niedrigem spezifischem Widerstand. Das Auftreffen von energiereichen Elektronen mit großer Stromstärke auf ein Substrat führt zu dessen elektrostatischer Aufladung, wodurch die Ortsauflösung des Elektronenstrahls verringert wird. Damit einher geht eine reduzierte Kontrolle des Depositionsprozesses. Darüber hinaus ist die Verwendung hoher Beschleunigungsspannungen wegen der damit einhergehenden Schädigung der empfindlichen Halbleiterbauelemente unverwünscht. Neben den Parametern des Elektronenstroms hat die Anmelderin den Einfluss der Verarbeitung des Metallcarbonyls auf den spezifischen Widerstand des deponierten Materials untersucht.

Der vorliegenden Erfindung liegt daher das Problem zu Grunde, ein einfacheres Verfahren zum elektronenstrahlinduzierten Abscheiden von leitfähigem Material aus einem Metallcarbonyl anzugeben, das die oben genannten Nachteile und Einschränkungen zumindest zum Teil vermeidet.

### 3. Zusammenfassung der Erfindung

Gemäß einem Ausführungsbeispiel der vorliegenden Erfindung wird dieses Problem durch ein Verfahren nach Anspruch 1 gelöst. In einer Ausführungsform umfasst das Verfahren zum elektronenstrahlinduzierten Abscheiden von elektrisch leitfähigem Material das Bereitstellen zumindest eines Elektronenstrahls an einer Stelle eines Substrats, das Aufbewahren von Dikobaltoktocarbonyl bei einer ersten Temperatur und das Erwärmen von Dikobaltoktocarbonyl auf zumindest eine zweite Temperatur vor dem Bereitstellen an die Stelle, an der der zumindest eine Elektronenstrahl auftrifft.

Die Anmelderin hat überraschend herausgefunden, dass - neben den Parametern des Elektronenstrahls - die Behandlung des Metallcarbonyls einen entscheidenden Einfluss auf das Abscheiden von leitfähigem Material hat. Durch das Aufbewahren des Metallcarbonyl bei Temperaturen deutlich unterhalb der Raumtemperatur (300 K) lässt sich eine spontane Umwandlung eines Metallcarbonyls, beispielsweise von Dikobaltoktocarbonyl (Co₂(CO)₈) in Tetrakobaltdodecarbonyl (Co₄(CO)₁₂) unter Bildung von Kohlenstoffmonooxid (CO) vermeiden. Durch die Bildung von CO in dem Vorratsbehälter wird neben dem Metallcarbonyl auch Kohlenstoffmonooxid an der Stelle der Deposition bereitgestellt und teilweise in das sich abscheidende Material eingebaut. Der Anteil der metallischen Komponente in dem Deponat wird damit verkleinert und dessen spezifischer Widerstand vergrößert. Da erst das Bereitstellen des Metallcarbonyls bei hinreichend hohen Temperaturen die Deposition von Material mit niedrigem spezifischem Widerstand erlaubt, wird das Metallcarbonyl von dem Einleiten in die Vakuumkammer erwärmt. Durch diese Maßnahmen können zuverlässig leitfähige Deponate hergestellt werden. In dem erfindungsgemäßen Verfahren wird Dikobaltoktocarbonyl (Co₂(CO)₈) als Metallcarbonyl verwendet. Es können jedoch auch andere Metallcarbonyle, beispielsweise mit einem der Metallzentralatome Chrom (Cr), Eisen (Fe), Mangan (Mn), Molybdän (Mo), Nickel (Ni), Tellur (Te), Rhenium (Rh), Ruthenium (Ru), Vanadium (V) Wolfram (W), usw. eingesetzt werden. Ferner ist es denkbar zwei oder mehrere Metallverbindungen in Kombination an der Stelle des Auftreffens des Elektronenstrahls bereitzustellen.

Vorzugsweise umfasst die erste Temperatur für das Metallcarbonyl einen Bereich von 230 K bis 320 K, bevorzugt von 240 K bis 290 K und besonders bevorzugt von 250 K bis 260 K. Die ideale Temperatur ist von dem Material und den Randbedingungen abhängig, die durch das Gaszuführungssystem definiert werden.

In einer bevorzugten Ausführungsform umfasst die zweite Temperatur für das Metallcarbonyl einen Bereich von 265 K bis 320 K, bevorzugt von 270 K bis 300 K und besonders bevorzugt von 275 K bis 280 K.

In einer besonders bevorzugten Ausführungsform des erfindungsgemäßen Verfahrens werden der Elektronenstrahl und das Metallcarbonyl zum Füllen eines Vias verwendet.

Vorzugsweise weist der Elektronenstrahl zu Beginn des Füllens eine Wiederholzeitdauer (refresh time) von 20 Millisekunden bis 0,2 Millisekunden, bevorzugt von 5 Millisekunden bis 0,8 Millisekunden und besonders bevorzugt von 2,5 Millisekunden bis 1,6 Millisekunden auf. In einer bevorzugten Ausführungsform weist der Elektronenstrahl am Ende des Füllens eine geringere, vorzugsweise eine um einen Faktor zehn geringere Wiederholzeitdauer wie zu Beginn des Füllens auf.

In einer bevorzugten Ausführungsform des erfindungsgemäßen Verfahrens weist der Elektronenstrahl zu Beginn des Füllens eine Verweilzeitdauer (dwell time) von 2000 Nanosekunden bis 10 Nanosekunden, bevorzugt von 500 Nanosekunden bis 40 Nanosekunden und besonders bevorzugt von 250 Nanosekunden bis 160 Nanosekunden auf. In einer günstigen Ausführungsform weist der Elektronenstrahl am Ende des Füllens eine geringere, vorzugsweise eine um einen Faktor zwei geringere Verweilzeitdauer wie zu Beginn des Füllens auf.

In einer besonders bevorzugten Ausführungsform des erfindungsgemäßen Verfahrens wird der Quotient aus Wiederholzeitdauer und Verweilzeitdauer beim Füllen eines Kontaktlochs mit steigendem Aspektverhältnis vergrößert.

In einer weiteren besonders bevorzugten Ausführungsform des erfindungsgemäßen Verfahrens weist das abgeschiedene leitfähige Material einen spezifischen Widerstand kleiner als 100 µΩ·cm auf.

Bevorzugt ist ein Zuführungssystem für das Metallcarbonyl ausgebildet, um das aus dem Metallcarbonyl entstehende Kohlenstoffdioxid aus einer Vakuumkammer abzusaugen.

Vorzugsweise umfasst die Vakuumkammer neben dem Elektronenstrahl keine zusätzlichen Wärmequellen.

In einer bevorzugten Ausführungsform des erfindungsgemäßen Verfahrens wird der Elektronenstrahl zum Auffinden der zu bearbeitenden Stelle und/oder zur Kontrolle der Abscheidung des elektrisch leitfähigen Materials und/oder seiner Umgebung verwendet. Eine Vorrichtung zum elektronenstrahlinduzierten Abscheiden von leitfähigem Material weist ein Elektronenstrahlgerät zum Bereitstellen zumindest eines Elektronenstrahls an einer Stelle eines Substrats auf, einen Vorratsbehälter zum Aufbewahren eines zumindest einen Metallcarbonyls bei einer ersten Temperatur und eine Vorrichtung zum Erwärmen des zumindest einen Metallcarbonyls auf zumindest eine zweite Temperatur vor dem Bereitstellen an eine Stelle, an der der zumindest eine Elektronenstrahl auftrifft.

Weitere Ausführungsformen des erfindungsgemäßen Verfahrens sind in weiteren abhängigen Patentansprüchen definiert.

### 4. Beschreibung der Zeichnungen

In der folgenden detaillierten Beschreibung werden derzeit bevorzugte Ausführungsbeispiele der Erfindung unter Bezugnahme auf die Zeichnungen beschrieben, wobei
- Fig. 1: eine schematische Darstellung einer beispielhaften Vorrichtung zur Durchführung des Verfahrens zeigt, wobei auf ein in einer Vakuumkammer befindliches Substrat durch die kombinierte Einwirkung eines Metallcarbonyls und eines fokussierten Elektronenstrahls elektrisch leitfähiges Material abgeschieden werden kann;
- Fig. 2: eine schematische, vergrößerte Darstellung eines von einer ersten Verdrahtungsebene durch mehrere Schichten eines Mehrschichtsystems auf eine zweite Verdrahtungsebene geätzten Vias zeigt; und
- Fig. 3: einen schematischen Schnitt durch das Via der Fig. 2 zeigt, das mit einer Ausführungsform des erfindungsgemäßen Verfahrens mit leitfähigem Material gefüllt worden ist.

### 5. Detaillierte Beschreibung bevorzugter Ausführungsbeispiele

Im Folgenden werden bevorzugte Ausführungsformen des erfindungsgemäßen Verfahrens und der erfindungsgemäßen Vorrichtung genauer erläutert.

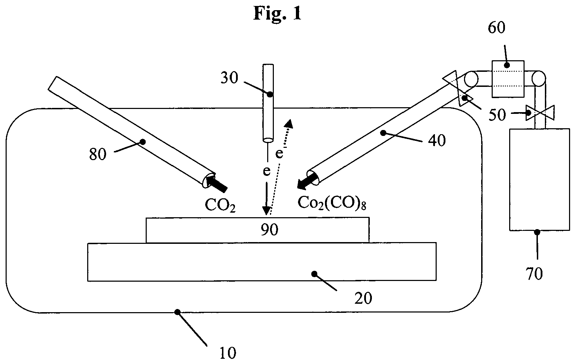

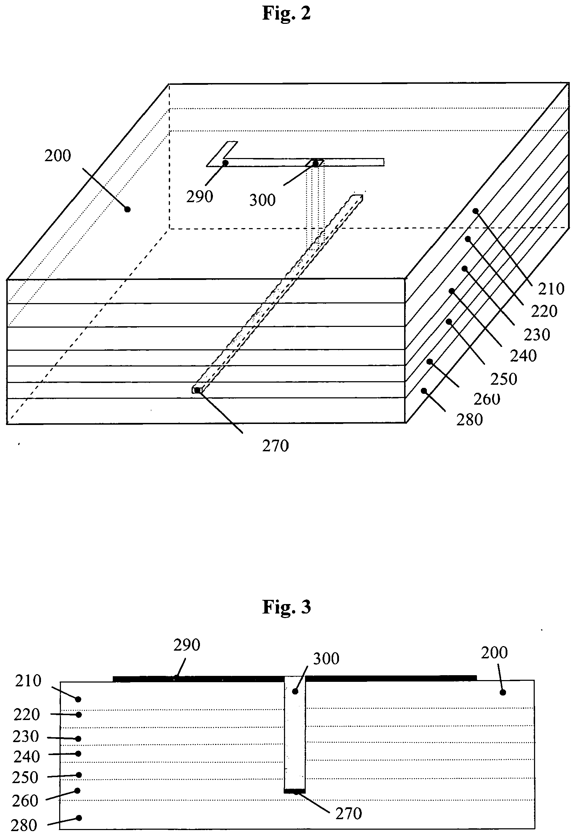

Wie in Fig. 1 schematisch dargestellt, wird in einer Vakuumkammer 10 auf einem Probenhalter 20 ein Substrat 90 angeordnet, auf dem leitfähiges Material abgeschieden werden soll. In den Figuren 2 und 3 umfasst das Substrat 90 ein Mehrschichtsystem 200. Der Elektronenstrahl zur Durchführung des erfindungsgemäßen Verfahrens stammt aus einem Elektronenstrahlgerät 30, das beispielsweise ein gegebenenfalls modifiziertes Rasterelektronenmikroskop ist.

In dem in Fig. 1 schematisch dargestellten bevorzugten Ausführungsbeispiel der vorliegenden Erfindung wird als Metallcarbonyl Dikobaltoktocarbonyl (Co₂(CO)₈) verwendet. Alternative Ausführungsformen des erfindungsgemäßen Verfahrens lassen den Einsatz von Metallcarbonylen mit anderen Metallzentralatomen, wie etwa Cr, Fe, Ni, Mo, V und W zu, um nur einige Beispiele zu nennen. Es ist ferner denkbar zwei oder mehrere Metallcarbonyle jeweils über ein eigenes Ventil durch einen einzigen oder durch separate Einlässe in die Vakuumkammer 10 einzulassen (in Fig. 1 nicht dargestellt). Alternativ zu einem auf den Elektronenstrahl gerichteten Zuführungssystem 40 für das Metallcarbonyl, können das erste und/oder die mehreren Metallcarbonyle auch ungerichtet in die Vakuumkammer 10 eingelassen werden.

Das Metallcarbonyl Co₂(CO)₈ wird in einem Vorratsbehälter 70 aufbewahrt. Der Vorratsbehälter weist eine Kühlvorrichtung und eine Temperaturregelung auf. Damit kann der Inhalt des Behälters 70 bei einer definierten Temperatur gelagert werden. Insbesondere ermöglicht der Vorratsbehälter 70 ein Aufbewahren des Dikobaltoktocarbonyls unterhalb der Raumtemperatur. Es hat sich als vorteilhaft erwiesen Co₂(CO)₈ bei im Wesentlichen 253 K aufzubewahren. Bei dieser Temperatur kann eine spontane Umwandlung von Dikobaltoktocarbonyl in Tetrakobaltdodecacarbonyl unter Freisetzung von CO verhindert bzw. hinreichend verlangsamt werden.

Falls in wesentlichem Ausmaß CO in dem Vorratsbehälter 70 gebildet wird, wird das Kohlenstoffmonooxid zusammen mit Co₂(CO)₈ in der Vakuumkammer 10 an der Stelle der Deposition bereitgestellt. Dabei ist der tatsächlich vorhandene Gasmengenstrom des Dikobaltoktocarbonyls kleiner als der experimentell bestimmte Gasmengenstrom durch das Zuführungssystem 40. Dieses zusätzliche CO wird zumindest teilweise in das sich abscheidende Material eingebaut. Durch den vermehrten Einbau von Kohlenstoff und Sauerstoff in das deponierte Material wird der Anteil der metallischen Komponente verkleinert. Dies führt zu einem größeren spezifischen Widerstand des Deponats.

Die Vorrichtung 60 kann das aus dem Vorratsbehälter 70 kommende Co₂(CO)₈ auf eine einstellbare Temperatur erwärmen. Dies ist notwendig, da erst das Bereitstellen des Metallcarbonyls an der Stelle des Auftreffens des Elektronenstrahls auf das Substrat 90 bei hinreichend hohen Temperaturen zum Abscheiden von leitfähigem Material mit niedrigem spezifischem Widerstand führt. Es hat sich herausgestellt, dass die Zufuhr des Dikobaltoktocarbonyls über den Einlass 40 bei einer Temperatur von etwa 278 K zu leitfähigem Material mit kleinem spezifischen Widerstand führt. Die Vorrichtung 60 erlaubt es ferner die Temperatur des Co₂(CO)₈ während des Abscheidevorgangs zu verändern. Da die günstige Einlasstemperatur für Dikobaltoktocarbonyl unterhalb der Raumtemperatur liegt, kann in einer alternativen Ausführungsform die zum Erwärmen des Metallcarbonyls benötigte Energie auch der Umgebung entnommen werden, die Vorrichtung 60 kann ausgebildet werden das Erwärmen des Metallcarbonyls auf diesem Wege zu ermöglichen. Es ist ferner denkbar, dass die Vorrichtung 60 beide beschriebene Möglichkeiten des Erwärmens in einer Ausführungsform kombiniert.

Die Ventile 50 in dem Zuführungssystem 40 ermöglichen das Bereitstellen eines definierten Gasmengenstroms an der Stelle des Auftreffens des Elektronenstrahls auf das Substrat 90, bzw. das kontrollierte Zuführen von Co₂(CO)₈ aus dem Vorratsbehälter 70 in die Heizvorrichtung 60. In der in Fig. 1 dargestellten bevorzugten Ausführungsform wird das Metallcarbonyl an der Stelle des Elektronenstrahls kontinuierlich bereitgestellt Die Ventile 50 machen es in einer alternativen Ausführungsform möglich, den Gasmengenstrom in dem Zuführungssystem 40 zeitlich zu variieren.

Ein wichtiger Teil des Zuführungssystems 40 ist die in Fig. 1 dargestellte Absaugvorrichtung 80. Diese macht es möglich, das in dem Elektronenstrahl aus dem Metallcarbonyl entstehende Kohlenstoffdioxid im Wesentlichen am Ort des Entstehens aus der Vakuumkammer 10 abzusaugen. Da das CO₂ lokal an der Stelle des Auftreffens des Elektronenstrahls auf das Substrat 90 aus der Vakuumkammer 10 abgepumpt wird, bevor es sich in dieser verteilen und absetzen kann, wird eine Kontamination der Vakuumkammer 10 verhindert. Alternativ zu der in Fig. 1 gezeigten Ausführungsform mit zwei getrennten Systemen für Zufuhr 40 und Absaugung 80, kann das Zuführungssystem 40 für das Metallcarbonyl und die Absaugvorrichtung 80 für entstehendes Kohlenstoffdioxid in einem System kombiniert werden, beispielsweise durch zwei nebeneinander oder ineinander liegenden Röhren bzw. Kanülen.

Zur Initialisierung der Ätzreaktion wird vorzugsweise ausschließlich ein fokussierter Elektronenstrahl verwendet. Die Beschleunigungsspannung der Elektronen liegt in dem Bereich von 0,1 keV bis 30 keV Die Stromstärke des eingesetzten Elektronenstrahls variiert in dem Intervall zwischen 1 pA und 1 nA Allerdings könnten zusätzlich oder alternativ auch andere energieübertragende Mechanismen zum Einsatz kommen (z.B. ein fokussierter Laserstrahl und/oder ein unfokussierter Ionenstrahl). In günstigen Ausführungsformen des erfindungsgemäßen Verfahrens ist es jedoch nicht wünschenswert, dass innerhalb der Vakuumkammer 10 an Stellen außerhalb des Abscheidebereichs sich zusätzliche Wärmequellen befinden.

Die elektronenstrahlinduzierte Deposition wird neben der Maskenreparatur, hauptsächlich zum Verdrahten oder Neuverdrahten von mikroelektronischen Schaltungsteilen und zum direkten Deponieren von leitfähigen Verbindungen zwischen mikroelektromechanischen Systemen (MEMS) verwendet. Verschiedene Ausführungsformen des erfindungsgemäßen Verfahrens können für die erwähnten verschiedenen Anwendungsgebiete eingesetzt werden. Im Folgenden wird eine bevorzugte Ausführungsform für das Füllen von tiefen Vias mit großem Aspektverhältnis zum Verbinden von mikroelektronischen Schaltungsblöcken näher erläutert. Das Aspektverhältnis bezeichnet das Verhältnis aus der Tiefe bzw. der Höhe einer Struktur zu ihrer kleinsten lateralen Ausdehnung.

Die Fig. 2 zeigt ein Mehrschichtsystem 200, das auf seiner Oberseite eine erste Verdrahtungsebene aufweist, von der die elektrische Leitung 290 dargestellt ist. Die Schichten 210, 220, 230, 240, 250 und 280 sind in dem Beispiel der Fig. 2 Halbleiterschichten unterschiedlicher Zusammensetzung und/oder Dotierung. Es ist jedoch auch möglich, dass eine, mehrere oder alle der Schichten 210, 220, 230, 240, 250 und 280 Isolatorschichten repräsentieren. In der Isolatorschicht 260 ist eine zweite Verdrahtungsebene eingebettet, die metallisch leitende Verbindungen aufweist, symbolisiert durch die elektrische Leitung 270. In Fig. 2 ist ein Via 300 von der elektrischen Leitung 290 der ersten Verdrahtungsebene auf die elektrische Leitung 270 der zweiten Verdrahtungsebene durch Ätzung freigelegt.

Die Fig. 3 präsentiert einen Schnitt durch das Via 300 des Mehrschichtsystems 200 der Fig. 2, nach dessen Füllen mit einer Ausführungsform des erfindungsgemäßen Verfahrens. Zum Herstellen einer elektrischen Verbindung mit niedrigem spezifischen Widerstand in dem Via 300 zwischen den elektrischen Leitungen 270 und 290 beträgt die Wiederholzeitdauer (refresh time) des Elektronenstrahls zu Beginn des Abscheidevorgangs, d.h. am Boden des Kontaktlochs im Wesentlichen 2 ms (Millisekunden). Dieser Parameter verringert sich gegen Ende des Füllvorgangs am oberen Ende des Kontaktlochs 300 um etwa eine Größenordnung auf im Wesentlichen 0,2 ms. Zu Beginn des Füllens im Bereich der elektrischen Leitung 270 verbleibt der Elektronenstrahl im Wesentlichen 200 ns (Nanosekunden) auf einer Stelle. Am oberen Ende des Kontaktlochs am Ende des Füllens verkleinert sich die Verweilzeit im Wesentlichen auf 100 ns. Der Elektronenstrahl wies in diesem Ausführungsbeispiel eine Energie von 1 keV auf und seine Stromstärke lag in dem Bereich zwischen 1 pA und 50 pA. Der Durchmesser des Elektronenstrahls lag bei etwa 4 nm. Der Ausdruck "im Wesentlichen" bedeutet hier, wie auch an den anderen Stellen dieser Beschreibung eine Angabe im Rahmen der Messgenauigkeit.

Wie in dem vorangehenden Abschnitt dargestellt, ändert sich der Quotient aus Wiederholzeitdauer und Verweildauer während des Füllens des Kontaktlochs 300. Dieser Quotient zeigt zudem eine Abhängigkeit von dem Aspektverhältnis des zu füllenden Kontaktlochs. Mit steigendem Aspektverhältnis ist es zur Erzielung von Deponaten mit niedrigem spezifischem Widerstand günstig, den Quotienten aus Wiederholzeitdauer und Verweilzeitdauer zu vergrößern.

Das erfindungsgemäße Verfahren erlaubt es Material mit einem spezifischen Widerstand von kleiner als 100 µΩ·cm abzuscheiden. Dieser Zahlenwert liegt zwar noch immer etwa um den Faktor 20 über dem spezifischen Widerstand von metallischem Kobalt. Der erreichte Zahlenwert des spezifischen Widerstands liegt jedoch in der gleichen Größenordnung, wie der von Lau et al. angegebene Bestwert von 45 µΩ·cm (Y.M. Lau, P.C. Chee, J.T.L. Thong an V. Ng, "Propertiers and applications of cobalt-based material produced by electron-beam induced deposition", J. Vac. Sci. Technol. A 20(4), 1295-1302 (2002)). Dieser Wert konnte allerdings nur unter speziellen experimentellen Bedingungen erreicht werden, nämlich mit großen Elektronenströmen, großen Elektronenenergien und großen Verweilzeitdauern des Elektronenstrahls an einer Stelle. Unter diesen experimentellen Bedingungen ist ein Füllen eines Kontaktlochs mit Material, dessen spezifischer Widerstand in dem von Lau et al. angegebenen Bereich liegt, nicht möglich.

## Patentansprüche

1. Verfahren zum elektronenstrahlinduzierten Abscheiden von elektrisch leitfähigem Material, aufweisend:
a. Bereitstellen zumindest eines Elektronenstrahls an einer Stelle eines Substrats (90), wobei der mindestens eine Elektronenstrahl eine Stromstärke im Intervall zwischen 1 pA und 1 nA aufweist;
b. Aufbewahren von Dikobaltoktocarbonyl bei einer ersten Temperatur von 250 K bis 260 K;
c. Erwärmen des Dikobaltoktocarbonyls auf zumindest eine zweite Temperatur von 275 K bis 280 K. vor dem Bereitstellen an der Stelle (90), an der der zumindest eine Elektronenstrahl auftrifft.

2. Verfahren nach Anspruch 1, wobei der Elektronenstrahl und das Dikobaltcarbonyl zum Füllen eines Vias (300) verwendet werden.

3. Verfahren nach Anspruch 2, wobei der Elektronenstrahl zu Beginn des Füllens die Wiederholzeitdauer von 20 Millisekunden bis 0,2 Millisekunden, bevorzugt von 5 Millisekunden bis 0,8 Millisekunden und besonders bevorzugt von 2,5 Millisekunden bis 1,6 Millisekunden aufweist.

4. Verfahren nach einem der Ansprüche 2-3 wobei der Elektronenstrahl am Ende des Füllens eine geringere, vorzugsweise eine um einen Faktor zehn geringere Wiederholzeitdauer wie zu Beginn des Füllens aufweist.

5. Verfahren nach einem der Ansprüche 2-4, wobei der Elektronenstrahl zu Beginn des Füllens die Verweilzeitdauer von 2000 Nanosekunden bis 10 Nanosekunden, bevorzugt von 500 Nanosekunden bis 40 Nanosekunden und besonders bevorzugt von 250 Nanosekunden bis 160 Nanosekunden aufweist.

6. Verfahren nach einem der Ansprüche 2-5, wobei der Elektronenstrahl am Ende des Füllens eine geringere, vorzugsweise eine um einen Faktor zwei geringere Verweilzeitdauer wie zu Beginn des Füllens aufweist.

7. Verfahren nach einem der vorhergehenden Ansprüche 2-6, wobei der Quotient aus Wiederholzeitdauer und Verweilzeitdauer beim Füllen eines Vias (300) mit steigendem Aspektverhältnis vergrößert wird.

8. Verfahren nach einem der vorhergehenden Ansprüche, wobei ein Zuführungssystem für das Dikobaltoktocarbonyl (40, 80) ausgebildet ist, um das aus dem Dikobaltoktocarbonyl entstehende Kohlenstoffdioxid aus einer Vakuumkammer (10) abzusaugen.

9. Verfahren nach einem der vorhergehenden Ansprüche, wobei die Vakuumkammer (10) neben dem Elektronenstrahl keine zusätzlichen Wärmequellen aufweist.

10. Verfahren nach einem der vorhergehenden Ansprüche, wobei der Elektronenstrahl zum Auffinden der zu bearbeitenden Stelle und/ oder zur Kontrolle der Abscheidung des elektrisch leitfähigen Materials und/oder seiner Umgebung verwendet wird.

## Claims

1. Method for the electron-beam-induced deposition of electrically conductive material, comprising:
a. providing at least one electron beam at a point of a substrate (90), the at least one electron beam having a current intensity in the range of between 1 pA and 1 nA;
b. storing dicobalt octocarbonyl at a first temperature of 250 K to 260 K;
c. heating the dicobalt octocarbonyl to at least a second temperature of 275 K to 280 K, before provision at the point (90) at which the at least one electron beam is incident.

2. Method according to Claim 1, wherein the electron beam and the dicobalt carbonyl are used for filling a via (300).

3. Method according to Claim 2, wherein, at the start of filling, the electron beam has the repetition time of 20 milliseconds to 0.2 milliseconds, preferably of 5 milliseconds to 0.8 milliseconds, and particularly preferably of 2.5 milliseconds to 1.6 milliseconds.

4. Method according to either of Claims 2-3, wherein the electron beam has a lower repetition time, preferably a repetition time which is lower by a factor of ten, at the end of filling than at the start of filling.

5. Method according to one of Claims 2-4, wherein, at the start of filling, the electron beam has the dwell time of 2000 nanoseconds to 10 nanoseconds, preferably of 500 nanoseconds to 40 nanoseconds, and particularly preferably of 250 nanoseconds to 160 nanoseconds.

6. Method according to one of Claims 2-5, wherein the electron beam has a lower dwell time, preferably a dwell time which is lower by a factor of two, at the end of filling than at the start of filling.

7. Method according to one of the preceding Claims 2-6, wherein the quotient of repetition time and dwell time is increased during the filling of a via (300) with an increasing aspect ratio.

8. Method according to one of the preceding claims, wherein a feed system for the dicobalt octocarbonyl (40, 80) is designed for exhausting the carbon dioxide which emerges from the dicobalt octocarbonyl from a vacuum chamber (10).

9. Method according to one of the preceding claims, wherein the vacuum chamber (10), besides the electron beam, does not have any additional heat sources.

10. Method according to one of the preceding claims, wherein the electron beam is used for locating the point to be processed and/or for controlling the deposition of the electrically conductive material and/or the environment thereof.

## Revendications

1. Procédé de dépôt induit par rayon électronique d'un matériau électriquement conducteur, comprenant :
a. fourniture d'au moins un rayon électronique en un endroit d'un substrat (90), l'au moins un rayon électronique possédant une intensité de courant dans l'intervalle entre 1 pA et 1 nA;
b. conservation d'octacarbonyle de dicobalt à une première température de 250 K à 260 K ;
c. chauffage de l'octacarbonyle de dicobalt à au moins une deuxième température de 275 K à 280 K avant la fourniture à l'endroit (90) au niveau duquel est incident l'au moins un rayon électronique.

2. Procédé selon la revendication 1, le rayon électronique et l'octacarbonyle de dicobalt étant utilisés pour remplir un trou de liaison (300).

3. Procédé selon la revendication 2, le rayon électronique présentant, au début du remplissage, la durée de répétition de 20 millisecondes à 0,2 milliseconde, de préférence de 5 millisecondes à 0,8 milliseconde et particulièrement de préférence de 2,5 millisecondes à 1,6 milliseconde.

4. Procédé selon l'une des revendications 2 et 3, le rayon électronique, à la fin du remplissage, présentant une durée de répétition plus faible, de préférence plus faible d'un facteur dix, qu'au début du remplissage.

5. Procédé selon l'une des revendications 2 à 4, le rayon électronique présentant, au début du remplissage, la durée de séjour de 2000 nanosecondes à 10 nanosecondes, de préférence de 500 nanosecondes à 40 nanosecondes et particulièrement de préférence de 250 nanosecondes à 160 nanosecondes.

6. Procédé selon l'une des revendications 2 à 5, le rayon électronique, à la fin du remplissage, présentant une durée de séjour plus faible, de préférence plus faible d'un facteur deux, qu'au début du remplissage.

7. Procédé selon l'une des revendications 2 à 6, le quotient de la durée de répétition par la durée de séjour lors du remplissage d'un trou de liaison (300) étant agrandi à mesure que le rapport d'aspect augmente.

8. Procédé selon l'une des revendications précédentes, un système d'acheminement pour l'octacarbonyle de dicobalt (40, 80) étant formé afin d'aspirer le dioxyde de carbone produit à partir de l'octacarbonyle de dicobalt hors d'une chambre sous vide (10).

9. Procédé selon l'une des revendications précédentes, la chambre sous vide (10) ne possédant aucune source de chaleur supplémentaire en plus du rayon électronique.

10. Procédé selon l'une des revendications précédentes, le rayon électronique étant utilisé pour trouver l'endroit à usiner et/ou pour contrôler le dépôt du matériau électriquement conducteur et/ou son environnement.
